# EUROPÄISCHE PATENTSCHRIFT

(11) **EP 2 351 473 B1**
(45) Veröffentlichungstag und Bekanntmachung des Hinweises auf die Patenterteilung: **05.09.2012**
(21) Anmeldenummer: 09736181.0
(22) Anmeldetag: 07.10.2009
(51) Int. Cl.: H05K 5/00, H05K 5/02, H05K 5/06, B60R 16/023

(54) **ELEKTRONISCHES GERÄT MIT BECHERGEHÄUSE UND VERFAHREN ZUR HERSTELLUNG DESSELBEN**
ELECTRONIC DEVICE HAVING A CAN HOUSING AND METHOD FOR PRODUCING THE SAME
APPAREIL ÉLECTRONIQUE AVEC UN BOÎTIER TRONCONIQUE ET SON PROCÉDÉ DE FABRICATION

(30) Priorität: 14.10.2008 DE 102008051547
(43) Veröffentlichungstag der Anmeldung: 03.08.2011
(73) Patentinhaber: Continental Automotive GmbH, 30165 Hannover (DE)
(72) Erfinder: SCHOBER, Franz, 93077 Bad Abbach (DE)
(86) Internationale Anmeldenummer: PCT/EP2009/063032
(87) Internationale Veröffentlichungsnummer: WO 2010/043525

(56) Entgegenhaltungen:
- DE-A1- 2 747 894
- DE-A1- 3 524 035
- DE-A1- 3 936 906
- US-A- 3 766 439

## Beschreibung

Die Erfindung betrifft ein elektronisches Gerät mit Bechergehäuse und ein Verfahren zur Herstellung desselben. Das Bechergehäuse weist eine offene Stirnseite auf. Über die Stirnseite ist ein Einschub in das Bechergehäuse einführbar. Der Einschub weist eine bestückte Leiterplatte und einen Mehrkontaktstecker auf.

Dieses Einschub-Bechergehäusekonzept ist ein weit verbreitetes Steuergerätekonzept, das aus der gattungsgemäßen Druckschrift DE 3936906 C2 für die Kfz-Elektronik bekannt ist, um das elektronische Gerät vor Kontaminationen zu schützen. Dazu weist der Mehrkontaktstecker nicht nur Kontaktelemente auf, sondern ist von einem Steckerkragen umgeben, in dem die Steckelemente des Mehrkontaktsteckers angeordnet sind, wobei die Kontaktelemente mit einer Kunststoffmasse umspritzt sind, die mit dem Steckerkragen eine einstückige Einheit bildet. An dieser Einheit aus Kontaktelementen, Kontaktträger und Steckerkragen ist eine Leiterplattenbaugruppe aus bestückter Leiterplatte angeordnet und bildet einen Einschub, der in das Bechergehäuse eingeführt werden kann, das an einer offenen Stirnseite eine umlaufende Dichtung aufweist, welche beim Zusammenbau des elektronischen Geräts das Bechergehäuse abdichtet, indem ein an den Steckerkragen angespritzter Deckel die offene Stirnseite des Bechergehäuses abdeckt.

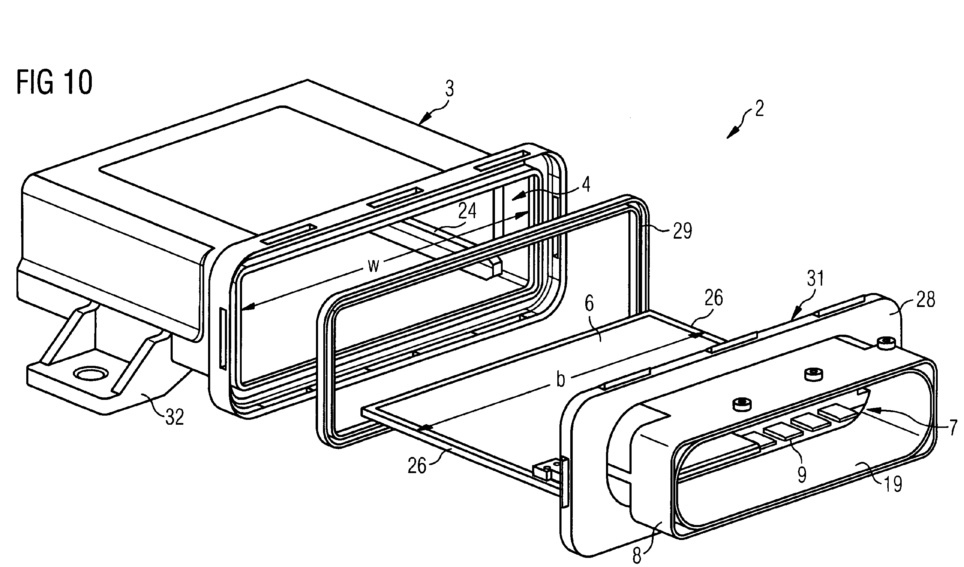

Ein derartiges bekanntes Einschub-Bechergehäusekonzept wird mit Figur 10 gezeigt. Das Konzept weist ein Kunststoffbechergehäuse 3 auf mit einer offenen Stirnseite 4 und einer lichten Weite w, wobei an der offenen Stirnseite 4 eine umlaufende Nut 30 angeordnet ist, die ein Dichtelement 29 aufnehmen kann. Eine Leiterplattenbaugruppe 31, die aus einer bestückten Leiterplatte 6 und dem Mehrkontaktstecker 7 besteht, kann in das Bechergehäuse 3 eingeschoben werden, wobei die Randbereiche 26 der Leiterplatte 6 in das Bechergehäuse 3 entlang der Führungsnuten 24 gleiten. Dabei wird die offene Stirnseite 4 von einem an dem Mehrkontaktstecker 7 einstückig angespritzten Deckel 28 abgedeckt. Die Fügestelle zwischen Mehrkontaktstecker 7 und dem Bechergehäuse liegt damit nach außen und ist somit allen Umwelteinflüssen ausgesetzt.

Aus diesem Grund findet dieses Konzept vorwiegend in Innenräumen von Fahrzeugen eine Applikation und wird nicht für hermetisch abgedichtete elektronische Geräte eingesetzt. Eine Umsetzung dieses Bechergehäusekonzepts für dichte Steuergeräteapplikationen, insbesondere in der Fahrzeugtechnik, erfordert umfangreiche Dichtungsmaßnahmen an der Fügestelle zwischen Bechergehäuse 3 und Steckerbereich. Dazu muss die Verbindung zwischen Bechergehäuse 3 und Stecker mit Leiterplattenbaugruppe 31 zusätzlich hermetisch durch das Abdichtelement 29 abgedichtet werden.

Dabei kommen Zusatzmaterialien wie Silikoneinlegedichtungen oder Verklebungsmittel wie Polyuritankleber zum Einsatz. Derartige Abdichtungsmaßnahmen erfordern Zusatzprozesse und Zusatzmaterialien und verursachen somit erhöhte Material- und Fertigungskosten. Weiterhin erfordert das Einbringen von Dichtungsmaßnahmen einen erhöhten Raumbedarf, wie es Figur 10 mit der Dichtungsnut 30 zeigt, wodurch die Außenabmessungen derartiger elektronischer Geräte, insbesondere Steuergeräte für Kraftfahrzeuge, nachteilig vergrößert werden.

Aufgabe der Erfindung ist es, die Nachteile im Stand der Technik zu überwinden und ein neues Einschub-Bechergehäusekonzept zu entwickeln, das bei vermindertem Raumbedarf und ohne Abdichtelemente einen hermetischen Schutz für das elektronische Gerät bilden kann. Ferner ist es Aufgabe der Erfindung, ein Verfahren zur Herstellung eines derartigen elektronischen Gerätes zu schaffen.

Gelöst wird diese Aufgabe mit dem Gegenstand der unabhängigen Ansprüche 1 und 7. Vorteilhafte Weiterbildungen der Erfindung ergeben sich aus den abhängigen Ansprüchen.

Erfindungsgemäß wird ein elektronisches Gerät mit Bechergehäuse und ein Verfahren zur Herstellung desselben geschaffen. Das Bechergehäuse weist eine offene Stirnseite auf. Über die Stirnseite ist ein Einschub in das Bechergehäuse einführbar. Der Einschub weist eine bestückte Leiterplatte und einen Mehrkontaktstecker auf. Das Bechergehäuse weist einen integrierten Steckerkragen auf, der einstückig das Bechergehäuse verlängert und den Mehrkontaktstecker mit Kontaktelementen umgibt. Der Steckerkragen bildet eine Passung für einen Gegenstecker. Der Einsatz weist die Leiterplatte und einen Kontaktträger mit dem Mehrkontaktstecker ohne Steckerkragen auf. Dabei ist die Außenkontur des Kontaktträgers der Innenkontur des Steckerkragens des Bechergehäuses mindestens teilweise angepasst.

Ein derartiges elektronisches Gerät hat den Vorteil, dass keine Fügestelle zwischen einem Einschub und dem Bechergehäuse erforderlich ist. Vielmehr wird durch die Trennung von Mehrkontaktstecker und umgebendem Steckerkragen die Anzahl der zusammenzufügenden Komponenten vermindert. Da der Steckerkragen nun unmittelbar das Bechergehäuse verlängert und eine einstückige Einheit mit dem Bechergehäuse bildet, entfällt die in Figur 10 gezeigte Fügestelle aus außen liegender Dichtungsnut mit Abdichtelement und einer abdichtenden Deckelplatte für die offene Stirnseite des Bechergehäuses. Diese komplexen Bauteile entfallen vollständig, so dass die Lagerhaltung verringert werden kann, die Außenmaße des Gehäuses schrumpfen können und die Montagekosten für ein derartiges elektronisches Gerät deutlich sinken.

Vorzugsweise weist der Innenraum des Bechergehäuses Führungsrampen für ein Einführen der Leiterplatte in eine Endposition auf. Damit wird die Montage des Einschubs, der aus bestückter Leiterplatte und an der Leiterplatte fixiertem Mehrkontaktstecker ohne Steckerkragen besteht, vereinfacht. Dazu sind keinerlei Dichtelemente erforderlich. Durch das Anpassen der Außenkontur des Kontaktträgers an die Innenkontur des Steckerkragens des Bechergehäuses ergibt sich zwar keine hermetische Abdichtung, diese wird jedoch beim Einschieben eines Gegensteckelements in den Mehrkontaktstecker innerhalb des Steckerkragens erreicht. Eine doppelte Abdichtung ist für derartige Steuergeräte nicht erforderlich.

Dazu weist der Steckerkragen vorzugsweise eine Öffnung mit Abmessungen auf, die der Breite des Einschubs aus Leiterplatte mit Kontaktträger entspricht. Damit wird sichergestellt, dass eine Einschubeinheit aus Leiterplatte und Kontaktträger mit Kontakten des Mehrkontaktsteckers in das Bechergehäuse mit integralem Steckerkragen problemlos eingebaut werden kann. Der Innenraum des Bechergehäuses weist Klemmbereiche und Arretierungsbereiche für die Leiterplatte auf, wodurch sichergestellt wird, dass bei Erreichen einer Endposition die Leiterplatte mit Kontaktträgern in dem Bechergehäuse verankert wird. Darüber hinaus ist es vorgesehen, dass das Bechergehäuse in dem Innenraum seitliche Führungsnuten aufweist, die mit Randbereichen der Leiterplatte in Eingriff stehen. Diese seitlichen Führungsnuten geben der Leiterplatte in dem Innenraum des Bechergehäuses Schutz und sorgen dafür, dass die bestückte Leiterplatte problemlos in das Bechergehäuse mit integralem Steckerkragen eingepasst werden kann.

Das elektronische Gerät ist vorzugsweise ein Gerät eines Fahrzeugs und weist vorzugsweise ein Gerät der Gruppe elektronische Parkbremse (EPB), elektronische Führungsvorrichtung, Motorsteuerungsvorrichtung, Transmissionssteuervorrichtung, Antiblockiervorrichtung (ABS) oder elektronische Stabilitätssteuervorrichtung (ESP) auf. Das elektronische Gerät kann aufgrund der Einpassung des Mehrkontaktsteckers in den Steckerkragen auch im Motorbereich eines Fahrzeugs angeordnet werden, da eine hermetische Abdichtung durch den zugehörigen Gegenstecker erfolgt, der mit einem Dichtungselement zur Innenkontur des Steckerkragens ausgestattet ist.

Ein Verfahren zur Herstellung eines elektronischen Geräts mit Bechergehäuse weist nachfolgende Verfahrensschritte auf. Zunächst wird ein Bechergehäuse mit integralem Steckerkragen, der in seinen lichten Abmessungen dem Innenraum des Bechergehäuses entspricht, hergestellt. Außerdem wird eine Leiterplatte mit Bestückung hergestellt, deren Breite einer lichten Weite des Bechergehäuses entspricht. Schließlich wird noch ein Kontaktträger mit Kontaktelementen eines Mehrkontaktsteckers hergestellt, wobei die Außenkontur des Kontaktträgers der Innenkontur des Steckerkragens entspricht.

Danach erfolgt zunächst ein Verbinden des Kontaktträgers mit der Leiterplatte zu einem kompakten Einschub. Anschließend wird der kompakte Einschub in das Bechergehäuse unter Positionieren des Kontaktträgers mit dem Mehrkontaktstecker in dem Steckerkragen des Bechergehäuses eingeführt.

Dieses Verfahren hat den Vorteil, dass es weniger Prozessschritte erfordert, um ein elektronisches Gerät mit einem Bechergehäusekonzept herzustellen. Die Herstellungsschritte sind derart vereinfacht, dass auch ungeschultes Personal den Zusammenbau von kompaktem Einschub und Bechergehäuse mit Steckerkragen ausführen kann. Dabei kann das Bechergehäuse mit integriertem Steckerkragen mittels Spritzgusstechnik in einem einzigen Spritzgussschritt hergestellt werden und die Kontaktelemente können mittels Spritzgussverfahren in den Kontaktträger selbst eingebettet werden.

Da Spritzgussanlagen für ein Spritzgussverfahren von Kontaktträgern und von Bechergehäusen automatisiert sind, ist eine präzise Massenfertigung der Komponenten des elektronischen Geräts möglich. Alternativ können zur Herstellung des Kontaktträgers zunächst Kontaktelemente hergestellt werden, die in ein vorgefertigtes Spritzgussteil mit der Außenkontur des Kontaktträgers in vorgefertigten schlitzförmigen Führungsöffnungen des Spritzgussteils eingeführt und kraftschlüssig oder stoffschlüssig mit dem Spritzgussteil zu einem Kontaktträger verbunden werden. Diese Verfahrensvariante hat den Vorteil, dass kein Spezialwerkzeug zum Spritzen von Kontaktelementen beim Spritzgussverfahren vorgehalten werden muss, sondern vielmehr ein Massenteil in Form des vorgefertigten Spritzgussteils mit Außenkontur des Kontaktträgers mit vorgefertigten schlitzförmigen Führungsöffnungen bereit gestellt werden kann und mit entsprechenden Assemblerautomaten die vorgefertigten Kontaktelemente in die Führungsöffnungen dieses Spritzgussteils eingeführt werden können.

Zusammenfassend ist festzustellen, dass mit dem neuen Bechergehäusekonzept das elektronische Gerät nachfolgende Vorteile gegenüber dem Stand der Technik aufweist:
1. durch die Verlegung der Trennebene in den Steckerinnenraum entfällt eine komplette Dichtungsebene;
2. damit werden Dichtungsmaterialien wie Polyuritanklebstoff oder Silikondichtungen eingespart; ferner werden
3. Prozessschritte eingespart, wie Dichtung aufbringen, Dichtung aushärten und/oder Dichtheitsprüfungen durchführen; darüber hinaus ergibt sich
4. eine Reduzierung der Außenmaße des Gehäuses in Bezug auf Gehäusehöhe und Gehäusebreite; ferner
5. eine Reduzierung des Gesamtgewichts aufgrund der reduzierten Baugröße;
6. dabei werden die Materialkosten reduziert; und
7. die Fertigungskosten vermindert; und schließlich
8. ein neues Steuergerätekonzept mit hermetisch geschützten Steuergerätekomponenten erreicht.

Die Erfindung wird nun anhand der beigefügten Figuren näher erläutert.
- Figur 1: zeigt eine schematische perspektivische Ansicht eines Bechergehäuses gemäß einer Ausführungsform der Erfindung;
- Figur 2: zeigt eine schematische perspektivische Ansicht eines kompakten Einschubs für das Bechergehäuse gemäß Figur 1;
- Figur 3: zeigt eine schematische perspektivische Ansicht eines elektronischen Geräts gemäß einer Ausführungsform der Erfindung;
- Figuren 4 bis 9: zeigen schematische Ansichten von Gerätekomponenten des elektronischen Geräts gemäß der Ausführungsform der Erfindung;

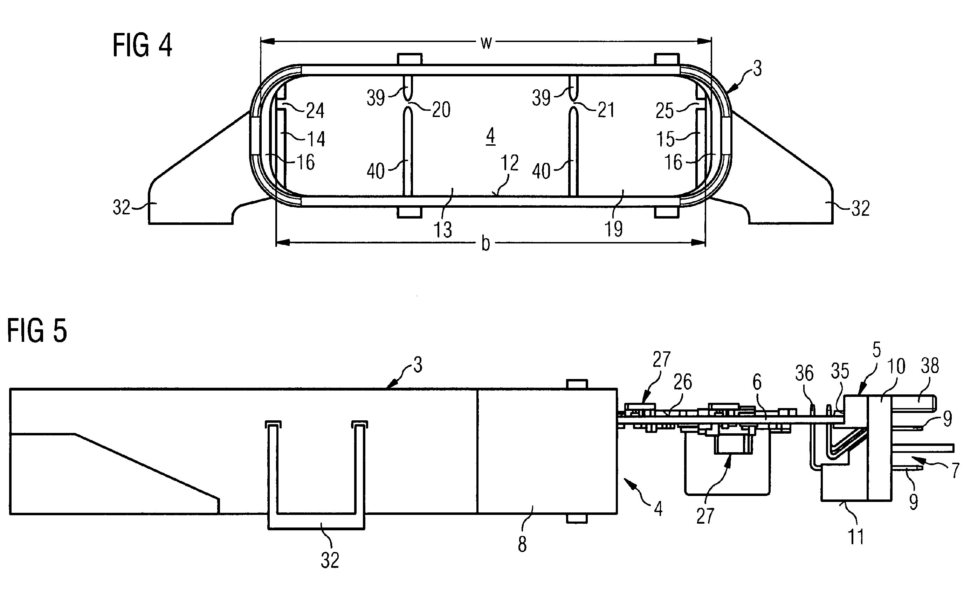

- Figur 4: zeigt eine schematische Stirnseitenansicht des Bechergehäuses;
- Figur 5: zeigt eine schematische Seitenansicht des Bechergehäuses nach teilweisem Einbringen eines kompakten Einschubs in das Bechergehäuse gemäß Figur 4;

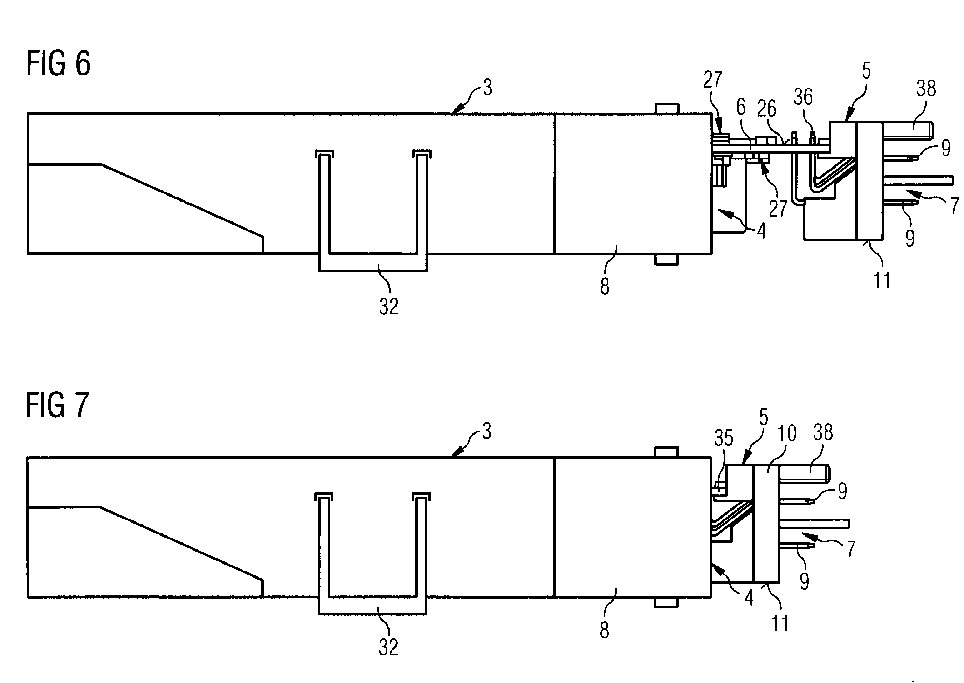

- Figur 6: zeigt eine schematische Seitenansicht des Bechergehäuses gemäß Figur 5 nach weiterem Einschieben des Einschubs;
- Figur 7: zeigt eine schematische Seitenansicht des Bechergehäuses gemäß Figur 6 nach fast vollständigem Einbringen des Einschubs in das Bechergehäuse;

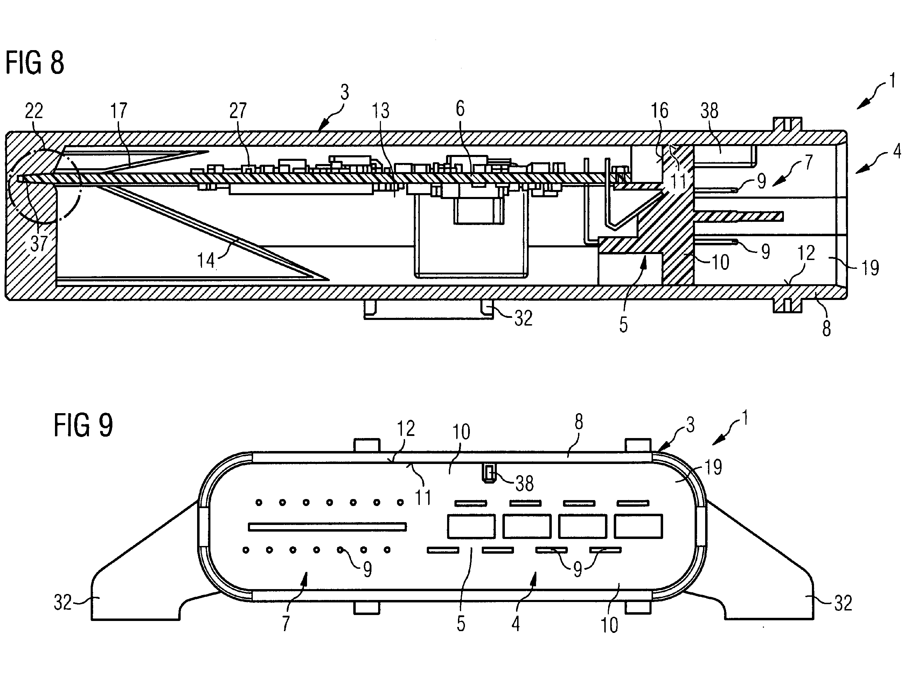

- Figur 8: zeigt einen schematischen Querschnitt durch das elektronische Gerät nach vollständigem Einbringen des Einschubs gemäß Figur 7;
- Figur 9: zeigt eine schematische Stirnseitenansicht des elektronischen Geräts gemäß Figur 8;
- Figur 10: zeigt eine schematische perspektivische und auseinander gezogene Ansicht eines elektronischen Geräts gemäß eines bekannten Bechergehäusekonzepts.

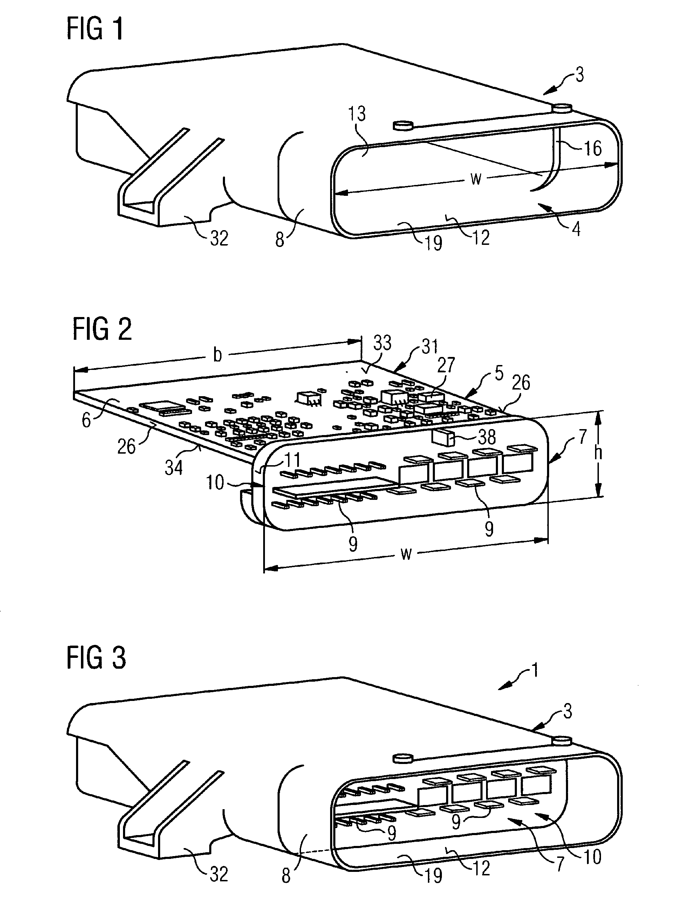

Figur 1 zeigt eine schematische perspektivische Ansicht eines Bechergehäuses 3 gemäß einer Ausführungsform der Erfindung. Dieses Bechergehäuse 3 weist Befestigungslaschen 32 auf, mit denen das Bechergehäuse 3 beispielsweise in einem Fahrzeug fixiert werden kann. Ferner ist integral an das Bechergehäuse 3 auf der offenen Stirnseite 4 ein Steckerkragen 8 angespritzt, dessen Innenkontur 12 eine lichte Weite w aufweist, die der lichten Weite des Innenraums des Bechergehäuses 3 entspricht. Ferner ist beim Übergang von dem Steckerkragen 8 auf den Innenbereich des Bechergehäuses 3 ein Anschlag als Endposition 16 im Innenraum des Bechergehäuses 3 zu erkennen, der eine Arretierung für den in Figur 2 gezeigten Einschub 5 bildet.

Figur 2 zeigt eine schematische perspektivische Ansicht eines kompakten Einschubs 5 für das Bechergehäuse 3 gemäß Figur 1. Dieser kompakte Einschub 5 umfasst eine Leiterplatte 6 mit Randbereichen 26, die auf ihrer Oberseite 33 und ihrer Unterseite 34 mit Bauelementen bestückt sein kann. Diese Leiterplatte 6 ist mit einem Mehrkontaktstecker 7 verbunden, der jedoch keinen Steckerkragen aufweist, sondern vielmehr nur Kontaktelemente 9 in einem Kontaktträger 10 besitzt. Außerdem ist an den Kontaktträger eine Kodierrippe 38 angeformt, die zur Führung und Kodierung eines Gegensteckers dient. Die Außenkontur 11 des Kontaktträgers 10 ist dabei sowohl in der Breite als auch in der Höhe h an die lichten Dimensionen des integralen Steckerkragens 8, wie er in Figur 1 gezeigt wird, angepasst. Die Breite b der Leiterplatte ist darüber hinaus dem Abstand der in Figur 4 gezeigtren Führungsnuten angepasst.

Figur 3 zeigt eine schematische perspektivische Ansicht eines elektronischen Geräts 1 gemäß einer Ausführungsform der Erfindung nach Zusammenbau der in Figur 1 und Figur 2 gezeigten Gerätekomponenten. Dazu wird lediglich der kompakte Einschub 5, wie er in Figur 2 gezeigt wird, in das Bechergehäuse 3 mit integralem Steckerkragen 8 eingeschoben, bis die in Figur 1 gezeigte Endposition 16 für den Kontaktträger 10, wie er in Figur 2 gezeigt wird, erreicht ist. Beispielsweise durch Schnapphaken oder Schrauben kann der Mehrkontaktstecker 7 in dem Steckerkragen 8 fixiert werden.

Da grundsätzlich und standardmäßig die Abdichtung des Steckerinnenraums durch die Montage des Gegensteckers sichergestellt ist, wird somit automatisch beim Einbringen eines Gegensteckers in den Mehrkontaktstecker 7 mit dem Steckerkragen 8 eine hermetische Abdichtung erreicht, ohne dass zusätzliche Trennebenen abgedichtet werden müssen. Die Trennebene zwischen Leiterplattenbaugruppe 31 und Bechergehäuse 3 wird somit in den Innenbereich des Mehrkontaktsteckers 7 mit Steckerkragen 8 verlegt, wobei die Integration des Steckerkragens 8 mit dem Bechergehäuse 3 zu einem einzigen Spritzgussteil die Montage der Leiterplattenbaugruppe 31 durch die offene Stirnfläche 4 sicherstellt.

Mit den Figuren 4 bis 9 werden schematische Ansichten von Gerätekomponenten des elektronischen Geräts 1 gemäß der Ausführungsform der Erfindung gezeigt. Dazu zeigt Figur 4 eine schematische Stirnseitenansicht des Bechergehäuses 3. Diese Stirnseitenansicht gewährleistet einen Einblick in den Innenraum 13 des Bechergehäuses 3 und zeigt gleichzeitig die bereits oben erwähnten äußeren Befestigungslaschen 32, die eine sichere Montage eines derartigen Bechergehäuses 3 beispielsweise in einem Fahrzeug ermöglichen.

Der Innenraum 13 weist unterschiedliche Klemmbereiche 20 und 21 zwischen oberen Klemmrippen 39 und unteren Klemmrippen 40 im hinteren Teil des Bechergehäuses 3 auf. An den Seiten sind Führungsnuten 24 und 25, in welche die Randbereiche der Leiterplatte eingeführt werden können, angeordnet. Außerdem sind An den Seiten im hinteren Bereich des Bechergehäuses 3 unteren Führungsrampen 14 und 15 und oberen Führungsrampen 17 und 18 angeordnet, die das hintere Ende einer Leiterplatte führen. Der Abstand der seitlichen Führungsnuten 24 und 25 ist für die Breite b der einzuschiebenden Leiterplatte entscheidend. Die hinteren Klemmbereiche 20 und 21 sind in ihrer Größe der Leiterplattendicke angepasst.

Figur 5 zeigt eine schematische Seitenansicht des Bechergehäuses 3 nach teilweisem Einbringen des kompakten Einschubs 5 in das Bechergehäuse 3 gemäß Figur 4. Die Bestückung 27 der Leiterplatte 6 ist derart an die lichte Höhe des Bechergehäuses 3 angepasst, dass die unterschiedlichen Bauelemente der Bestückung 27 ohne weiteres in dem Innenraum des Bechergehäuses 3 angeordnet werden können. Die Leiterplatte 6 ist mit einem vorderen Rand 35 an dem Kontaktträger 10 fixiert, wobei der Kontaktträger 10 aus einer Spritzgussmasse bestehen kann, welche die Kontaktelemente 9 aufweist. Dabei sind innere Enden 36 der Kontaktelemente 9 zur Leiterplatte 6 hin abgebogen und mit entsprechenden stromführenden Leiterbahnen der Leiterplatte 6 verbunden. Diese Verbindung kann kraftschlüssig, formschlüssig oder auch stoffschlüssig ausgeführt sein.

Figur 6 zeigt eine schematische Seitenansicht des Bechergehäuses 3 gemäß Figur 5 nach weiterem Einbringen des Einschubs 5 in den Innenraum des Bechergehäuses 3. Dabei werden die Bestückungen 27 der Leiterplatte 6 in dem Bechergehäuse 3 angeordnet und die Leiterplatte 6 in den Führungsnuten, wie sie Figur 4 zeigt, geführt.

Figur 7 zeigt eine schematische Seitenansicht des Bechergehäuses 3 gemäß Figur 6 nach fast vollständigem Einbringen des Einschubs 5. Dazu ist die Außenkontur 11 des Kontaktträgers 10 an die Innenkontur des Steckerkragens 8 mindestens teilweise angepasst, so dass durch weiteres Einschieben des kompakten Einschubs 5 in das Bechergehäuse 3 der Mehrkontaktstecker fertig montiert werden kann.

Figur 8 zeigt einen schematischen Querschnitt durch das elektronische Gerät 1 nach vollständigem Einbringen des Einschubs 5 gemäß Figur 7. Dabei hat der kompakte Einschub 5 eine Endposition 16, an die der Kontaktträger 10 anstößt, erreicht. In dieser Position sind in dem Steckerkragen 8 die entsprechenden Kontaktelemente 9 angeordnet, die zusammen mit dem Steckerkragen 8 nun den Mehrkontaktstecker 7 bilden, wobei der Kontaktträger 10 mit seiner Außenkontur 11 an die Innenkontur 12 des Steckerkragens 8 mindestens teilweise angepasst ist. Eine Abdichtung gegenüber gasförmigen, flüssigen oder festen Verunreinigungen wird erst erreicht, wenn in den Steckerkragen 8 ein entsprechender Gegenstecker eingeführt ist. Im hinteren Bereich sind die oben erwähnten unteren Führungsrampen 14 und oberen Führungsrampen 17 zu erkennen, die einen hinteren Randbereich der Leiterplatte 6 in einen Arretierungsbereich 22 einführen, so dass die Leiterplatte 6 einerseits durch die seitlichen Führungsnuten und andererseits durch den Arretierungsbereich 22 im Innenraum 13 des Bechergehäuses 3 fixiert wird.

Figur 9 zeigt eine schematische Stirnseitenansicht des elektronischen Geräts 1 gemäß Figur 8. Diese Stirnseitenansicht zeigt die offene Stirnseite 4 des Steckerkragens 8, in dem die Außenkontur 11 des Kontaktträgers 10 in die Innenkontur 12 des Steckerkragens 8 mindestens teilweise eingepasst ist. Diese Position kann bei Erreichung der Endposition 16, wie sie in Figur 8 gezeigt wird, mechanisch, kraftschlüssig oder formschlüssig oder stoffschlüssig fixiert werden.

Figur 10 zeigt eine schematische auseinander gezogene perspektivische Ansicht eines elektronischen Geräts 2 gemäß eines bekannten Bechergehäusekonzepts, das einleitend bereits beschrieben wurde, so dass eine Wiederholung an dieser Stelle entfällt.

### Bezugszeichenliste

- 1: elektronisches Gerät (Ausführungsform)
- 2: elektronisches Gerät (Stand der Technik)
- 3: Bechergehäuse
- 4: offene Stirnseite
- 5: Einschub
- 6: bestückte Leiterplatte
- 7: Mehrkontaktstecker
- 8: Steckerkragen
- 9: Kontaktelement
- 10: Kontaktträger
- 11: Außenkontur des Kontaktträgers
- 12: Innenkontur des Steckerkragens
- 13: Innenraum des Bechergehäuses
- 14: Führungsrampe (untere)
- 15: Führungsrampe (untere)
- 16: Endposition
- 17: Führungsrampe (obere)
- 18: Führungsrampe (obere)
- 19: Öffnung des Steckerkragens
- 20: Klemmbereich
- 21: Klemmbereich
- 22: Arretierungsbereich
- 24: seitliche Führungsnut
- 25: seitliche Führungsnut
- 26: Randbereich der Leiterplatte
- 27: Bestückung der Leiterplatte
- 28: Deckel
- 29: Abdichtelement
- 30: Nut
- 31: Leiterplattenbaugruppe
- 32: Befestigungslasche
- 33: Oberseite
- 34: Unterseite
- 35: vorderer Rand
- 36: innere Enden der Kontaktelemente
- 37: hinterer Randbereich der Leiterplatte
- 38: Kodierrippe
- 39: obere Klemmrippe
- 40: untere Klemmrippe

- b: Breite des Einschubs
- h: Höhe des Kontaktträgers
- w: lichte Weite des Bechergehäuses

## Patentansprüche

1. Elektronisches Gerät mit Bechergehäuse (3) aufweisend:
- ein Bechergehäuse (3) mit einer offenen Stirnseite (4), über die ein Einschub (5) in das Bechergehäuse (3) einführbar ist, wobei der Einschub (5) eine bestückte Leiterplatte (6) und einen Mehrkontaktstecker (7) aufweist,
**dadurch gekennzeichnet, dass** das Bechergehäuse (3) einen integrierten Steckerkragen (8) aufweist, der einstückig das Bechergehäuse (3) verlängert und den Mehrkontaktstecker (7) mit Kontaktelementen (9) umgibt und eine Passung für einen Gegenstecker bildet, und wobei der Einschub (5) die Leiterplatte (6) und einen Kontaktträger (10) mit dem Mehrkontaktstecker (7) ohne Steckerkragen (8) aufweist, wobei die Außenkontur (11) des Kontaktträgers (10) der Innenkontur (12) des Steckerkragens (8) mindestens teilweise angepasst ist.

2. Elektronisches Gerät nach Anspruch 1, **dadurch gekennzeichnet, dass** der Innenraum (13) des Bechergehäuses (3) Führungsrampen (14, 15) für ein Einführen der Leiterplatte (6) in eine Endposition (16) aufweist.

3. Elektronisches Gerät nach Anspruch 1 oder Anspruch 2,
**dadurch gekennzeichnet, dass** der Steckerkragen (8) eine Öffnung (19) mit Abmessungen aufweist, die der Breite (b) des Einschubs (5) aus Leiterplatte (6) mit Kontaktträger (10) entspricht.

4. Elektronisches Gerät nach einem der vorhergehenden Ansprüche,
**dadurch gekennzeichnet, dass** das Bechergehäuse (3) einen Innenraum (13) aufweist, der Klemmbereiche (20, 21) und Arretierungsbereiche (22) für die Leiterplatte (6) aufweist.

5. Elektronisches Gerät nach Anspruch 1 oder Anspruch 2,
**dadurch gekennzeichnet, dass** das Bechergehäuse (3) in dem Innenraum (13) seitliche Führungsnuten (24, 25) aufweist, die mit Randbereichen (26) der Leiterplatte (6) in Eingriff stehen.

6. Elektronisches Gerät nach einem der vorhergehenden Ansprüche, **dadurch gekennzeichnet, dass** das elektronische Gerät (1) ein Gerät eines Fahrzeugs ist und vorzugsweise ein Gerät der Gruppe elektronische Parkbremse (EPB), elektronische Führungsvorrichtung, Motorsteuerungsvorrichtung, Transmissionssteuervorrichtung, Antiblockiervorrichtung (ABS) oder elektronische Sicherheitssteuerungsvorrichtung (ESP) aufweist.

7. Verfahren zur Herstellung eines elektronischen Geräts (1) mit Bechergehäuse (3), das folgende Verfahrensschritte aufweist:
- Herstellen eines Bechergehäuses (3) mit integralem Steckerkragen (8), der in seinen Abmessungen dem Innenraum (13) des Bechergehäuses (3) entspricht;
- Herstellen einer Leiterplatte (6) mit Bestückung (27), deren Breite (b) einer lichten Weite (w) des Bechergehäuses (3) entspricht;
- Herstellen eines Kontaktträgers (10) mit Kontaktelementen (9) eines Mehrkontaktsteckers (7), wobei die Außenkontur (11) des Kontaktträgers (10) der Innenkontur (12) des Steckerkragens (8) mindestens teilweise angepasst wird;
- Verbinden des Kontaktträgers (10) mit der Leiterplatte (6) zu einem kompakten Einschub (5);
- Einführen des kompakten Einschubs (5) in das Bechergehäuse (3) unter Positionieren des Kontaktträgers (10) mit dem Mehrkontaktstecker (7) in dem Steckerkragen (8) des Bechergehäuses (3).

8. Verfahren nach Anspruch 7, **dadurch gekennzeichnet, dass** das Bechergehäuse (3) mit integralem Steckerkragen (8) mittels Spritzgusstechnik hergestellt wird.

9. Verfahren nach Anspruch 7 oder Anspruch 8,
**dadurch gekennzeichnet, dass** die Kontaktelemente (9) mittels Spritzgussverfahren in den Kontaktträger (10) eingebettet werden.

10. Verfahren nach einem der Ansprüche 7 bis 9,
**dadurch gekennzeichnet, dass** zur Herstellung des Kontaktträgers (10) Kontaktelemente (9) hergestellt werden, die in ein vorgefertigtes Spritzgussteil mit der Außenkontur des Kontaktträgers (10) in vorgefertigten schlitzförmigen Führungsöffnungen des Spritzgussteils eingeführt und kraftschlüssig oder stoffschlüssig mit dem Spritzgussteil zu einem Kontaktträger (10) verbunden werden.

## Claims

1. Electronic device having a can housing (3) having:
- a can housing (3) with an open end face (4) via which a plug-in unit (5) can be inserted into the can housing (3), wherein the plug-in unit (5) has a populated printed circuit board (6) and a multicontact connector (7), **characterized in that** the can housing (3) has an integrated connector collar (8) which integrally extends the can housing (3) and surrounds the multicontact connector (7) with contact elements (9) and forms a fit for a mating connector, and wherein the plug-in unit (5) has the printed circuit board (6) and a contact carrier (10) with the multicontact connector (7) without the connector collar (8), wherein the outer contour (11) of the contact carrier (10) is at least partially matched to the inner contour (12) of the connector collar (8).

2. Electronic device according to Claim 1, **characterized in that** the interior (13) of the can housing (3) has guide ramps (14, 15) for insertion of the printed circuit board (6) into an end position (16).

3. Electronic device according to Claim 1 or Claim 2, **characterized in that** the connector collar (8) has an opening (19) with dimensions which correspond to the width (b) of the plug-in unit (5) composed of the printed circuit board (6) with the contact carrier (10).

4. Electronic device according to one of the preceding claims,
**characterized in that** the can housing (3) has an interior (13) which has clamping regions (20, 21) and locking regions (22) for the printed circuit board (6).

5. Electronic device according to Claim 1 or Claim 2, **characterized in that** the can housing (3) has, in the interior (13), lateral guide grooves (24, 25) which are in engagement with edge regions (26) of the printed circuit board (6).

6. Electronic device according to one of the preceding claims, **characterized in that** the electronic device (1) is a device of a vehicle and preferably has a device of the group comprising electronic parking brake (EPB), electronic guidance device, engine control device, transmission control device, antilock braking device (ABS) or electronic safety control device (ESP).

7. Method for producing an electronic device (1) having a can housing (3), which has the following method steps:
- manufacture of a can housing (3) with an integral connector collar (8) which corresponds in its dimensions to the interior (13) of the can housing (3);
- production of a printed circuit board (6) with populating elements (27), the width (b) of which printed circuit board (6) corresponds to a clear width (w) of the can housing (3);
- production of a contact carrier (10) with contact elements (9) of a multicontact connector (7), wherein the outer contour (11) of the contact carrier (10) is at least partially matched to the inner contour (12) of the connector collar (8);
- connection of the contact carrier (10) to the printed circuit board (6) to form a compact plug-in unit (5); and
- insertion of the compact plug-in unit (5) into the can housing (3) accompanied by positioning of the contact carrier (10) with the multicontact connector (7) in the connector collar (8) of the can housing (3).

8. Method according to Claim 7, **characterized in that** the can housing (3) is produced with an integral connector collar (8) by means of injection molding technology.

9. Method according to Claim 7 or Claim 8,
**characterized in that** the contact elements (9) are embedded in the contact carrier (10) by means of an injection molding method.

10. Method according to one of Claims 7 to 9,
**characterized in that**, in order to produce the contact carrier (10), contact elements (9) are produced which are inserted into a prefabricated injection molded part with the outer contour of the contact carrier (10) in prefabricated slit-shaped guide openings in the injection molded part and are connected in a frictionally locking or materially joined fashion to the injection molded part to form a contact carrier (10).

## Revendications

1. Appareil électronique avec logement de boîtier (3) présentant :
- un logement de boîtier avec un front (4) ouvert, via lequel un tiroir enfichable (5) peut être introduit dans le logement de boîtier (3), dans lequel le tiroir enfichable (5) présente une carte à circuits imprimés (6) équipée et une prise multicontact (7),
**caractérisé en ce que** le logement de boîtier (3) présente une embase de prise (8) intégrée, qui d'un seul tenant prolonge le logement de boîtier (3) et entoure la prise multicontact (7) avec des éléments de contact (9) et forme un ajustement pour un connecteur homologue, et dans lequel le tiroir enfichable (5) présente la carte à circuits imprimés (6) et un support de contacts (10) avec la prise multicontact (7) sans embase de prise (8), dans lequel le contour extérieur (11) du support de contacts (10) est au moins partiellement adapté au contour intérieur (12) de l'embase de prise (8).

2. Appareil électronique selon la revendication 1, **caractérisé en ce que** l'espace intérieur (13) du logement de boîtier (3) présente des rampes de guidage (14, 15) pour l'introduction de la carte à circuits imprimés (6) dans une position finale (16).

3. Appareil électronique selon la revendication 1 ou la revendication 2, **caractérisé en ce que** l'embase de prise (8) présente une ouverture (19) avec des dimensions qui correspond à la largeur (b) du tiroir enfichable (5) constitué de la carte à circuits imprimés (6) avec support de contacts (10).

4. Appareil électronique selon l'une des revendications précédentes,
**caractérisé en ce que** le logement de boîtier (3) présente un espace intérieur (13) qui présente des zones de serrage (20, 21) et des zones d'arrêt (22) pour la carte à circuits imprimés (6).

5. Appareil électronique selon la revendication 1 ou la revendication 2,
**caractérisé en ce que** le logement de boîtier (3) présente dans l'espace intérieur (13) des rainures de guidage (24, 25) latérales qui sont en prise avec des zones de bordure (26) de la carte à circuits imprimés (6).

6. Appareil électronique selon l'une des revendications précédentes, **caractérisé en ce que** l'appareil électronique (1) est un appareil d'un véhicule et présente de préférence un appareil du groupe consistant en un frein de stationnement électronique (EPB), un dispositif de guidage électronique, un dispositif de commande de moteur, un dispositif de commande de transmission, un dispositif antiblocage (ABS) ou un dispositif électronique de commande de sécurité (ESP).

7. Procédé de fabrication d'un appareil électronique (1) avec logement de boîtier (3), qui présente les étapes de procédé suivantes :
- fabrication d'un logement de boîtier (3) avec embase de prise (8) intégrale qui correspond dans ses dimensions à l'espace intérieur (13) du logement de boîtier (3),
- fabrication d'une carte à circuits imprimés (6) avec équipement (27), dont la largeur (b) correspond à une largeur intérieure (w) du logement de boîtier (3) ;
- fabrication d'un support de contacts (10) avec des éléments de contact (9) d'une prise multicontact (7), dans lequel le contour extérieur (11) du support de contacts (10) est au moins partiellement adapté au contour intérieur (12) de l'embase de prise (8) ;
- raccordement du support de contacts (10) avec la carte à circuits imprimés (6) pour en faire un tiroir enfichable (5) compact ;
- introduction du tiroir enfichable (5) compact dans le logement de boîtier (3) en positionnant le support de contacts (10) avec la prise multicontact (7) dans l'embase de prise (8) du logement de boîtier (3).

8. Procédé selon la revendication 7, **caractérisé en ce que** le logement de boîtier (3) avec embase de prise (8) intégrale est fabriqué avec la technique de moulage par injection.

9. Procédé selon la revendication 7 ou la revendication 8,
**caractérisé en ce que** les éléments de contact (9) sont encastrés dans le support de contacts (10) par le procédé de moulage par injection.

10. Procédé selon l'une des revendications 7 à 9, **caractérisé en ce que**, pour fabriquer le support de contacts (10), des éléments de contact (9) sont fabriqués, lesquels sont introduits dans une partie moulée par injection et préfabriquée, avec le contour extérieur du support de contacts (10), dans des ouvertures de guidage préfabriquées et en forme de fente de la partie moulée par injection, et sont raccordés à la partie moulée par injection par liaison de force ou liaison de matière pour en faire un support de contacts (10).
